(19) Europäisches Patentamt
European Patent Office
Office européen des brevets

(11) Veröffentlichungsnummer: **0 309 791 B1**

# (12) EUROPÄISCHE PATENTSCHRIFT

(45) Veröffentlichungstag der Patentschrift:
25.09.91 Patentblatt 91/39

(51) Int. Cl.$^5$: **H03K 17/04, H01S 3/103**

(21) Anmeldenummer: **88114697.1**

(22) Anmeldetag: **08.09.88**

(54) Schnelle Ansteuerungsschaltung für eine Halbleiter-Laserdiode.

(30) Priorität: 21.09.87 DE 3731731

(43) Veröffentlichungstag der Anmeldung:
05.04.89 Patentblatt 89/14

(45) Bekanntmachung des Hinweises auf die
Patenterteilung:
25.09.91 Patentblatt 91/39

(84) Benannte Vertragsstaaten:
**DE FR GB IT**

(56) Entgegenhaltungen:
EP-A- 0 110 358
WO-A-85/04537
DE-A- 3 113 039

(56) Entgegenhaltungen:
TECHNISCHES MESSEN, Band 50, Nr. 2, Februar 1983, Seiten 49-54, München, DE; W.S. LUDOLF: "Grundlagen der optischen Übertragungstechnik - Eine Einführung für Anwender"
FEINWERKTECHNIK & MESSTECHNIK, Band 89, Nr. 5, Juli/August 1981, Seiten 225-228, München, DE; M. FABIAN: "Pulsschaltungen für Laserdioden"
IBM TECHNICAL DISCLOSURE BULLETIN, Band 9, Nr. 4, September 1966, Seiten 443-444, New York, US; D. SEITZER: "Multistage amplifier"
ELECTRONICS, Band 49, Nr. 16, 5. August 1976, Seiten 93-96, New York, US; J.T. O'-BRIEN: "Laser diodes provide high power for high-speed communications systems"

(73) Patentinhaber: Siemens Aktiengesellschaft
Wittelsbacherplatz 2
W-8000 München 2 (DE)

(72) Erfinder: Elias, Holger, Dipl.-Ing.
Im Malerwinkel 6
W-5340 Bad Honnef (DE)

**Beschreibung**

Die Erfindung betrifft eine schnelle Ansteuerungsschaltung für eine Halbleiter-Laserdiode zur Übertragung impulsförmiger Signale.

Die Übertragungskapazität von Lichtwellenleiter-Übertragungssystemen wird ständig erhöht. Eines der Probleme bei der Entwicklung schneller Lichtwellenleiter-Übertragungssysteme für Signale mit Bitraten oberhalb 1 Gbit/s ist die Ansteuerung der als optischer Sender verwendeten Halbleiter-Laserdiode, da die Ansteuerungsschaltung einerseits eine Pulsformung des Ausgangssignals vornehmen muß, um dieses zu versteilern und andererseits den erforderlichen Treiberstrom bereit zu stellen hat. Bei den betrachteten Übertragungsgeschwindigkeiten werden deshalb Ansteuerungsschaltungen eingesetzt, die mit Galliumarsenidhalbleitern bestückt sind. Derartige Galliumarsenidhalbleiter sind teurer als Halbleiter mit bipolarer Silizium-Technologie, außerdem treten höhere Exemplarstreuungen auf : im Hinblick auf einen bestimmten Treiberstrom ergibt sich auch eine höhere Leistungsaufnahme.

Aus der WO-A-8504537 ist eine Ansteuerungsschaltung für eine LED bekannt, die einen Differenz verstärker mit nachgeschaltetem Emitterfolger und außerdem weitere Stufen enthält, durch die die LED übersteuert und dadurch zu schnellerem Schalten angeregt wird. Außerdem wird im Hinblick auf eine höhere Schaltgeschwindigkeit eine Sättigung der Transistoren des Differenzverstärkers vermieden.

Aus der EP-A-0110358 sind Treiberschaltungen für Laserdioden bekannt, wobei eine der Treiberschaltungen einen Differenzverstärker enthält, bei dem der Kollektorwiderstand eines der Differenzverstärkertransistoren durch die Laserdiode ersetzt ist. Weiterhin werden Schaltungsanordnungen mit geringerer Verlustleistung dargestellt, die jeweils aus kondensatorgekoppelten einzelnen Transistorstufen bestehen, wobei die Laserdiode mit dem Kollektoranschluß und ein zusätzlicher Kondensator direkt oder über einen Widerstand mit dem Emitteranschluß des verwendeten Transistoranschluß verbunden sind.

In "Technisches Messen", Band 50, Nr. 2 vom Februar 1983, Seiten 49-54 sind Treiberstufen für optische Sender dargestellt und beschrieben, bei denen beispielsweise in den Bildern 8.8 und 8.9 zwischen einer eingangsseitigen Logikschaltung und der eigentlichen Treiberstufe ein Gleichstromkopplungsglied angeordnet ist.

Die Aufgabe bei der vorliegenden Erfindung besteht darin, eine Ansteuerungsschaltung der eingangs erwähnten Art zu entwickeln, an die bei Übertragungsgeschwindigkeiten zwischen 1 und 2 Gbit/s ohne Galliumarsenid-Bauelemente auskommt und außerdem möglichst einfach aufgebaut sein soll.

Erfindungsgemäß wird die Aufgabe durch eine schnelle Ansteuerungsschaltung mit dem im Kennzeichen des Patentanspruchs 1 angegebenen Merkmalen gelöst. Durch die Trennung in zwei Verstärkerstufen wird dabei die Begrenzung des Eingangssignals in einfacher Weise mittels eines emittergekoppelten Differenzverstärkers vorgenommen, der mit niedrigem Betriebsstrom arbeitet und damit weit unterhalb des Sättigungsbereichs der verwendeten Transistoren betrieben wird. Durch die Verwendung eines linear arbeitenden Endstufentransistors für die Erzeugung des Ausgangsstroms ergibt sich außerdem in vorteilhafter Weise die Möglichkeit, zusammen mit dem Nutzsignal Signale vergleichsweise sehr geringer Amplitude zu übertragen, die für die Regelung der Laserdiode und/oder für Telemetriezwecke benötigt werden.

Im Hinblick auf den geringen Aufwand bevorzugter Ausbildungen der erfindungsgemäßen schnellen Ansteuerungsschaltung sind in den Patentansprüchen 2 bis 4 beschrieben.

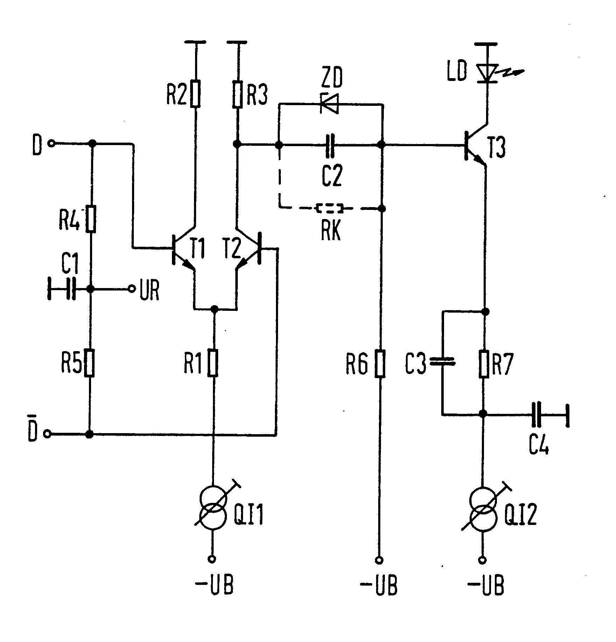

Die Erfindung soll im folgenden anhand eines in der Zeichnung dargestellten Ausführungsbeispieles näher erläutert werden.

In der Zeichnung sind mit D und $\overline{D}$ die beiden Eingangsanschlüsse der Ansteuerungsschaltung bezeichnet, die direkt mit den Basisanschlüssen eines ersten bzw. zweiten Transistors T1, T2 vom npn-Typ verbunden sind. Die Emitteranschlüsse der beiden Transistoren T1, T2 sind miteinander und über einen ersten Widerstand R1 mit einer ersten, einstellbaren Stromquelle QI1 verbunden, die Stromquelle ist an eine Betriebsspannungsquelle – UB angeschlossen. Die beiden Transistoren sind also nach Art eines emittergekoppelten Differenzverstärkers verbunden, der Kollektoranschluß des ersten Transistors ist über einen zweiten Widerstand R2 und der Kollektoranschluß des zweiten Transistors ist über einen dritten Widerstand R3 mit Bezugspotential verbunden. Zur symmetrischen Zuführung einer Referenzspannung sind der Basisanschluß des ersten Transistors T1 über eine vierten Widerstand R4 und der Basisanschluß des zweiten Transistors T2 über einen fünften Widerstand R5 mit einer Referenzspannungsquelle UR verbunden, die außerdem über einen ersten Kondensator C1 als Siebkondensator wechselstrommäßig mit Bezugspotential verbunden ist. An den Kollektoranschlüssen der beiden Transistoren T1, T2 liegt das begrenzte und versteilerte Eingangssignal an, vom Kollektor des zweiten Transistors T2 wird dieses Signal über ein Gleichstromkopplungsglied spannungsverschoben auf den Basisanschluß eines dritten Transistors T3 vom npn-Typ weitergeleitet. Das Gleichstromkopplungsglied besteht beim Ausführungsbeispiel aus der Parallelschaltung einer Zenerdiode ZD und eines zweiten Kondensators C2. Anstelle der Zenerdiode zur Pegelanpassung zwischen dem Kollektoranschluß des zweiten Transistors T2 und dem Basisanschluß des dritten Transistors T3 kann auch ein Kopplungswiderstand RK verwendet werden, der von einem konstanten Strom durchflossen wird. An diesem Widerstand fällt dann eine dem Konstantstrom proportionale Spannung ab, die ebenfalls zur Stromregelung des dritten Transistors T3 benutzt werden kann.

Zur Einstellung der Basisvorspannung ist der Basisanschluß des dritten Transistors T3 über einen sechsten Widerstand R6 mit der Betriebsspannungsquelle – UB verbunden. Der Emitteranschluß des dritten Transistors ist über die Parallelschaltung eines siebten Widerstandes R7 und eines dritten Kondensators C3 mit einer zweiten Stromquelle QI2 verbunden, die an die Betriebsspannungsquelle – UB angeschlossen ist. Die Schaltgeschwindigkeit des Differenzverstärkers ist durch RC-Glieder den Arbeitswiderstand des Differenzverstärkers in Parallelschaltung zum Eingangswiderstand der nachgeschalteten Verstärkerstufe in Verbindung mit der Kollektorkapazität der Differenzverstärkertransistoren und der Eingangskapazität der nachgeschalteten Verstärkerstufe begrenzt. Durch entsprechende Bemessung des dritten Kondensators (3 in Verbindung mit dem dritten Widerstand R3 kann die maximale Schaltgeschwindigkeit der Ansteuerschaltung eingestellt werden. Damit ist es möglich, mit bipolarer Siliziumtechnologie Schaltzeiten unter 200 pA für Treiberströme von I = 50 mA zu erzielen. Bei der Verwendung des Kopplungswiderstandes RK kann diese zweite Stromquelle entfallen und damit auch der zur zweiten Stromquelle wechselstrommäßig parallelgeschaltete vierte Kondensator C4. Der Kollektoranschluß des dritten Transistors T3 ist über die Laserdiode als elektrooptischem Wandler mit Bezugspotential verbunden.

Unter der Voraussetzung, daß der Emitterstrom des dritten Transistors T3 proportional dem Kollektorstrom des ersten bzw. zweiten Transistors T1, T2 ist, kann der Modulationsstrom für die Laserdiode in einfacher Weise mittels des Emitterstroms für die Transistoren T1, T2, also über die erste Stromquelle QI1, eingestellt werden.

Die Verwendung einer Zenerdiode ZD im Gleichstromkopplungsglied hat den Vorteil, daß durch Auswahl der Zenerdiode mit ensprechender Zenerspannung die Schaltung leicht an unterschiedliche Betriebsspannungen und Steuerströme angepaßt werden kann, die Verwendung eines Koppelwiderstands RK im Gleichstromkopplungsglied hat durch den Wegfall der zweiten Stromquelle QI2 den Vorteil, daß die Betriebsspannung der Gesamtschaltung um den Spannungsabfall an der zweiten Stromquelle verringert werden kann.

## Patentansprüche

1. Schnelle Ansteuerungsschaltung für eine Halbleiter-Laserdiode (LD) zur Übertragung impulsförmiger Signale (D, $\overline{D}$) mit einem eingangsseitigen emittergekoppelten Differenzverstärker (T1, T2), **dadurch gekennzeichnet, daß** der Differenzverstärker (T1, T2) auf einem niedrigen Betriebsstrom eingestellt ist, daß der Differenzverstärker über ein Gleichstromkopplungsglied (ZD, C2) mit einer weiteren Transistorverstärkerstufe (T3) in Emitterschaltung verbunden ist, deren Emitteranschluß über eine Widerstands-Kondensatorkombination (R7, C3) mit einer durch einen Kondensator (C4) überbrückten Stromquelle (Q12) verbunden ist, daß der Kollektoranschluß der Transistorverstärkerstufe (T3) über die Laserdiode (LD) mit Bezugspotential verbunden ist, wobei die Schaltgeschwindigkeit der Ansteuerschaltung durch Veränderung des dritten Kondensators (C3) und des mit dem Gleichstromkopplungsglied verbundenen Kollektorwiderstandes (R3) des ausgangsseitigen Differenzverstärkertransistors maximiert wird.

2. Schnelle Ansteuerungsschaltung nach Anspruch 1, **dadurch gekennzeichnet, daß** das Gleichstromkopplungsglied aus der Parallelschaltung einer Zenerdiode (ZD) und eines Kondensators (C2) besteht.

3. Schnelle Ansteuerungsschaltung nach Anspruch 1, **dadurch gekennzeichnet, daß** das Gleichstromkopplungsglied aus der Parallelschaltung eines Kopplungswiderstandes (RK) und eines Kondensators (C2) besteht.

4. Schnelle Ansteuerungsschaltung nach Ansprüchen 1 bis 3, **dadurch gekennzeichnet, daß** zwei Eingangsanschlüsse (D, $\overline{D}$) vorgesehen sind, an denen das Übertragungssignal und das invertierte Übertragungssignal anstehen, daß der Eingangsanschluß (D) für das Übertragungssignal mit dem Basisanschluß eines ersten Transistors (T1) und der Eingangsanschluß ($\overline{D}$) für das inverse Übertragungssignal mit dem Basisanschluß eines zweiten Transistors (T2) vom npn-Typ verbunden sind, daß die Emitteranschlüsse beider Transistoren (T1, T2) miteinander und über die Reihenschaltung eines ersten Widerstandes (R1) und eine erste einstellbare Stromquelle (QI1) mit einer Betriebsspannungsquelle (– UB) verbunden sind, daß der Kollektoranschluß des ersten Transistors (T1) über einen zweiten Widerstand (R2) und der Kollektoranschluß des zweiten Transistors (T2) über einen dritten Widerstand (R3) mit Bezugspotential verbunden sind, daß der Basisanschluß des ersten Transistors (T1) über einen vierten Widerstand (R4) und der Basisanschluß des zweiten Transistors (T2) über einen fünften Widerstand (R5) mit einer Referenzspannungsquelle (UR) verbunden sind, die über einen ersten Kondensator (C1) an Bezugspotential angeschlossen ist, daß der Kollektoranschluß des zweiten Transistors (T2) über das Gleichstromkopplungsglied mit dem Basisanschluß des dritten Transistors (T3) und mit einen Anschluß eines sechsten Widerstandes (R6) verbunden ist, daß der andere Anschluß des sechsten Widerstandes (R6) an die Betriebsspannungsquelle V(– UB) angeschlossen ist, daß der Kollektoranschluß des dritten Transistors (T3) über die Laserdiode (LD) mit Bezugspotential und über die Parallelschaltung eines dritten Kondensators (C3) und eines siebten Widerstandes (R7) mit einer zweiten Stromquelle (QI2) und mit einem vierten Kondensator (C4) verbunden ist, daß dieser Kondensator (C4) an Bezugspotential angeschlossen ist, daß die zweite Stromquelle (QI2) an die Betriebsspannungsquelle (– UB) angeschlossen ist und daß die Schaltgeschwindigkeit der Ansteuerschaltung mittels Veränderung des dritten Kondensators (C3) und des dritten Widerstandes (R3) maximiert wird.

## Claims

1. Fast control circuit for a semiconductor laser diode (LD) for transmitting pulsed signals (D, $\overline{D}$), having an emitter-coupled differential amplifier (T1, T2) on the input side, characterised in that the differential amplifier (T1, T2) is set on a low operating current, in that the differential amplifier is connected via a d.c. coupling element (ZD, C2) to a further transistor amplifier stage (T3) in common emitter circuit, whose emitter terminal is connected via a resistor-capacitor combination (R7, C3) to a current source (Q12) bridged by a capacitor (C4), and in that the collector terminal of the transistor amplifier stage (T3) is connected via the laser diode (LD) to reference potential, the switching speed of the control circuit being maximised by varying the third capacitor (C3) and the collector resistor (R3), connected to the d.c. coupling element, of the differencial amplifier transistor on the output side.

2. Fast control circuit according to Claim 1, characterised in that the d.c. coupling element consists of the parallel circuit of a Zener diode (ZD) and a capacitor (C2).

3. Fast control circuit according to Claim 1, characterised in that the d.c. coupling element consists of the parallel circuit of a coupling resistor (RK) and a capacitor (C2).

4. Fast control circuit according to Claims 1 to 3, characterised in that two input terminals (D, $\overline{D}$) are provided, at which the transfer signal and the inverted transfer signal are available, in that the input terminal (D) for the transfer signal is connected to the base terminal of a first transistor (T1) and the input terminal ($\overline{D}$) for the inverse transfer signal is connected to the base terminal of a second transistor (T2) of npn type, in that the emitter terminals of the two transistors (T1, T2) are connected to one another and, via the series circuit of a first resistor (R1) and a first adjustable current source (QI1), to an operating voltage source (– UB), in that the collector terminal of the first transistor (T1) is connected via a second resistor (R2), and the collector terminal of the second transistor (T2) is connected via a third resistor (R3) to reference potential, in that the base terminal of the first transistor (T1) is connected via a fourth resistor (R4), and the base terminal of the second transistor (T2) is connected via a fifth resistor (R5) to a reference voltage source (UR), which is connected via a first capacitor (C1) to reference potential, in that the collector terminal of the second transistor (T2) is connected via the d.c. coupling element to the base terminal of the third transistor (T3) and to a terminal of a sixth resistor (R6), in that the other terminal of the sixth resistor (R6) is connected to the operating voltage source (– UB), in that the collector terminal of the third transistor (T3) is connected via the laser diode (LD) to reference potential, and via the parallel circuit of a third capacitor (C3) and a seventh resistor (R7) to a second current source (QI2) and to a fourth capacitor (C4), in that this capacitor (C4) is connected to reference potential, in that the second current source (QI2) is connected to the operating voltage source (– UB), and in that the switching speed of the control circuit is maximised by means of varying the third capacitor (C3) and the third resistor (R3).

## Revendications

1. Circuit de commande rapide pour une diode laser à semiconducteurs (LD) pour la transmission de signaux impulsionnels (D, $\overline{D}$), comportant un amplificateur différentiel (T1, T2) à émetteurs couplés, situé côté entrée, caractérisé par le fait que l'amplificateur différentiel (T1, T2) est réglé sur un faible courant de service, que l'amplificateur différentiel est raccordé par l'intermédiaire d'un circuit de couplage à courant continu (ZD, C2), selon un montage en émetteur commun, avec un autre étage amplificateur à transistor (T3), la borne d'émetteur étant raccordée par une combinaison résistance-condensateur (R7, C3), à une source de courant (Q12) shuntée par un condensateur (C4), que la borne de collecteur de l'étage amplificateur à transistor (T3) est raccordée au potentiel de référence par l'intermédiaire de la diode laser (LD), la vitesse de commutation du circuit de commande étant rendue maximale au moyen d'une modification du troisième condensateur (C3) et de la résistance (R3), raccordée au circuit de couplage à courant continu, du transistor de l'amplificateur différentiel, situé côté sortie.

2. Circuit de commande rapide suivant la revendication 1, caractérisé par le fait que le circuit de couplage à courant continu est constitué par le branchement en parallèle d'une diode Zener (Z2) et d'un condensateur (C2).

3. Circuit rapide de commande suivant la revendication 1, caractérisé par le fait que le circuit de couplage à courant continu est constitué par le montage en parallèle d'une résistance de couplage (RK) et d'un condensateur (C2).

4. Circuit rapide de commande suivant les revendications 1 à 3, caractérisé par le fait qu'il est prévu deux bornes d'entrée (D, $\overline{D}$), auxquelles sont appliqués le signal de transmission et le signal de transmission inversé, que la borne d'entrée (D) pour le signal de transmission est raccordée à la borne de base d'un premier transistor (T1) et que la borne d'entrée ($\overline{D}$) pour le signal de transmission inversé est raccordée à la borne de base d'un second transistor (T2) du type npn, que les bornes d'émetteur des deux transistors (T1, T2) sont raccordées entre elles et par l'intermédiaire du circuit série formé d'une première résistance (R1) et d'une première source de courant réglable (QI1) à une source de tension de service (− UB), que la borne du collecteur du premier transistor (T1) est raccordée au potentiel de référence par l'intermédiaire d'une seconde résistance (R2) et la borne de collecteur du second transistor (T2), est reliée audit potentiel de référence par l'intermédiaire d'une troisième résistance (R3), que la borne de base du premier transistor (T1) est raccordée par l'intermédiaire d'une quatrième résistance, et la borne de base du second transistor (T2) est raccordée par l'intermédiaire d'une cinquième résistance (R5), à une source de tension de référence (UR), qui est raccordée au potentiel de référence par l'intermédiaire d'un premier condensateur (C1), que la borne de collecteur du second transistor (T2) est raccordée par l'intermédiaire du circuit de couplage à courant continu à la borne de base du troisième transistor (T3) et à une borne d'une sixième résistance (R6), que l'autre borne de la sixième résistance (R6) est raccordée à la source de tension de service (− UB), que la borne de collecteur du troisième transistor (T3) est raccordée par l'intermédiaire de la diode laser (LD) au potentiel de référence et par l'intermédiaire du montage en parallèle d'un troisième condensateur (C3) et d'une septième résistance (R7) à une seconde source de courant (QI2) et à un quatrième condensateur (C4), que ce condensateur (C4) est raccordé au potentiel de référence, que la seconde source de courant (QI2) est raccordée à la source de tension de service (− UB), et que la vitesse de commutation du circuit de commande est rendue maximale au moyen d'une modification du troisième condensateur (C3) et de la troisième résistance (R3).